# EUROPÄISCHE PATENTSCHRIFT

(11) **EP 2 826 064 B1**
(45) Veröffentlichungstag und Bekanntmachung des Hinweises auf die Patenterteilung: **21.10.2015**
(21) Anmeldenummer: 12715611.5
(22) Anmeldetag: 16.03.2012
(51) Int. Cl.: H01L 21/67

(54) **DRUCKÜBERTRAGUNGSEINRICHTUNG ZUM BONDEN VON CHIPS AUF EIN SUBSTRAT**
PRESSURE TRANSMITTING DEVICE FOR BONDING CHIPS ONTO A SUBSTRATE
SYSTÈME DE TRANSMISSION DE PRESSION POUR L'ASSEMBLAGE DE PUCES SUR UN SUBSTRAT

(43) Veröffentlichungstag der Anmeldung: 21.01.2015
(73) Patentinhaber: Ev Group E. Thallner GmbH, 4782 St. Florian am Inn (AT)
(72) Erfinder: WIMPLINGER, Markus, A-4910 Ried im Innkreis (AT); SIGL, Alfred, 94533 Ottmaring (DE)
(74) Vertreter: Schweiger, Johannes
(86) Internationale Anmeldenummer: PCT/EP2012/054650
(87) Internationale Veröffentlichungsnummer: WO 2013/135302

(56) Entgegenhaltungen:
- WO-A1-2011/152492
- JP-A- 2004 047 692
- US-A1- 2001 019 174
- US-A1- 2006 292 823
- US-A1- 2008 070 376
- US-A1- 2009 049 687
- US-A1- 2010 327 043

## Beschreibung

Die vorliegende Erfindung betrifft eine Druckübertragungseinrichtung und eine Bondvorrichtung zum Bonden einer Vielzahl von Chips auf ein Substrat gemäß den Ansprüchen 1 und 5 und ein Verfahren zum Bonden einer Vielzahl von Chips auf ein Substrat gemäß Anspruch 6.

In der Halbleiterindustrie existieren mehrere Möglichkeiten, unterschiedliche funktionelle Einheiten miteinander zu verbinden, insbesondere zu bonden. Eine dieser Möglichkeiten ist das Chip-to-Wafer (C2W)-Verfahren, bei welchem einzelne Chips mit einem Substrat einzeln gebondet werden. Ein weiteres wichtiges Verfahren stellt das sogenannte "advanced-chip-to-wafer" (AC2W)-Verfahren dar, bei welchem die Chips zunächst vorläufig (temporär) mit dem Substrat verbunden werden und eine permanente Verbindung in einem Bondschritt gemeinsam erfolgt, wobei alle Chips gleichzeitig mit dem Substrat permanent gebondet werden. Bei dem Bondschritt werden die Chips und das Substrat aufgeheizt, während die Chips auf das Substrat gepresst werden (Bondkraft).

Durch die vorgenannten Druck- und Heizvorgänge entstehen insbesondere bei den immer kleiner werdenden Strukturen technische Probleme, beispielsweise durch thermische Ausdehnung während des Aufheizens.

Es ist daher die Aufgabe der vorliegenden Erfindung, eine Druckübertragungseinrichtung beziehungsweise eine Bondvorrichtung anzugeben, mit der das vorgenannte Verfahren optimiert werden kann und Ausschuss beim Bonden minimiert wird.

Diese Aufgabe wird mit den Merkmalen der Ansprüche 1, 5 und 6 gelöst.

Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Zeichnungen angegebenen Merkmalen. Bei Wertebereichen sollen auch innerhalb der genannten Grenzen liegende Werte als Grenzwerte offenbart und in beliebiger Kombination beanspruchbar sein.

Grundgedanke der vorliegenden Erfindung ist es, eine Druckübertragungseinrichtung zum Bonden einer Vielzahl von Chips auf ein Substrat derart auszugestalten, dass diese eine gleitende Bewegung des Druckkörpers quer zur Bondrichtung B zulassend ausgebildet ist. Es ist jedoch von Vorteil, wenn Begrenzungsmittel zur Begrenzung der gleitenden Bewegung quer zur Bondrichtung B vorgesehen sind, insbesondere in Form von Fixiermitteln zur Fixierung der Druckübertragungseinrichtung an einem Haltekörper in der Bondrichtung B. Besonders vorteilhaft ist die Verwendung der vorliegenden Erfindung mit einem AC2W-Verfahren, bei welchem die Chips temporär mit dem Substrat verbunden werden und dann unter Verwendung der Druckübertragungseinrichtung in einem Bondprozess gebondet werden. Dabei ist es erfindungsgemäß von Vorteil, wenn vor der Druckübertragung der Aufheizvorgang auf die Bondtemperatur zumindest überwiegend abgeschlossen ist. Hierdurch kann der Druckkörper freier quer zur Bondrichtung B gleiten als bei einer anliegenden Bondkraft in Bondrichtung B.

Als Substrat kommt insbesondere ein Halbleiter, vorzugsweise ein Wafer, in Frage.

Durch die Erfindung wird das technische Problem von beim Bonden auftretenden Thermospannungen zwischen der Druckübertragungseinrichtung und der Chipoberflächen zumindest weitgehend gelöst, da nur noch die Spannungen des Druckkörpers selbst relevant sind, da dieser durch die erfindungsgemäße Gleitschicht von allen Bauteilen jenseits der Gleichschicht quer zur Bondrichtung B zumindest überwiegend entkoppelt ist. Die Gleitschicht erlaubt somit eine nahezu vollständig reibungsfreie Relativbewegung der an ihr angrenzenden Bauteile. Erfindungsgemäß ist die Gleitschicht insbesondere als, vorzugsweise überwiegend kohlenstoffhaltiger, Festkörper ausgebildet. Bevorzugt wird als Material Graphit, dessen Basalebenen insbesondere zumindest überwiegend normal zur Bondrichtung B ausgerichtet ist, gewählt.

Gemäß einer vorteilhaften Ausführungsform der Erfindung ist vorgesehen, dass die Fixiermittel quer zur Bondrichtung B elastisch ausgebildet sind. Die Fixiermittel können somit gleichzeitig für einen Zusammenhalt der Druckübertragungseinrichtung in Bondrichtung B sorgen, während die gleitende Bewegung des Druckkörpers quer zur Bondrichtung B zugelassen wird. Gleichzeitig können die Fixiermittel auf diese Weise als die oben beschriebenen Begrenzungsmittel wirken und nehmen somit mehrere erfindungsgemäße Funktionen ein.

Dabei ist es von besonderem Vorteil, wenn die Fixiermittel als Klemmen zur Klemmung eines Druckkörpers in Richtung des Haltekörpers, insbesondere mit dazwischen angeordneter Gleitschicht, ausgebildet sind. Diese Ausgestaltung ist besonders einfach und platzsparend realisierbar und erfüllt die obengenannten Mehrfachfunktionen.

In Weiterbildung der Erfindung ist vorgesehen, dass der Druckkörper, insbesondere hinsichtlich Material und/oder Abmessungen, derart ausgewählt wird, dass seine Wärmeausdehnungseigenschaften zumindest in Querrichtung zur Bondrichtung B mit den Wärmeausdehnungseigenschaften des Produktsubstrats korrespondieren. Bevorzugt wird als Material das Material des Substrats und/oder der Chips gewählt. Insbesondere ist es erfindungsgemäß von Vorteil, wenn die Abmessungen des Druckkörpers im Wesentlichen mit den Abmessungen des Substrats, insbesondere quer zur Bondrichtung B, übereinstimmen. Die Wärmeausdehnungseigenschaften umfassen insbesondere den thermischen Ausdehnungskoeffizienten des Druckkörpers und/oder des Substrats und/oder der Chips. Insbesondere, aber nicht ausschließend können Matierialklassen wie Metalle, Keramiken, Kunststoffe oder Verbundmaterialien verwendet werden. Im besonderen Si, CTE angepasstes Glas, also Glas, dessen thermischer Ausdehnungskoeffizient an den des Produktsubstrats angeglichen wurde, Niedrig-CTE Metalle etc. CTE angepasstes Glass und Niedrig-CTE Metalle sind auch unter den englischen Bezeichnungen "CTE matched glass" und "low CTE metals" bekannt. Bevorzugt werden vor allem Materialien, deren thermische Leitfähigkeit sehr hoch ist. Der thermische Ausdehnungskoeffizient von Silizium beispielsweise beträgt ca.2.6*10⁻⁶ K⁻¹. Der Absolutbetrag der Differenz der thermischen Ausdehnungskoeffizienten von Produktsubstrat und erfindungsgemäßer Ausführungsform ist kleiner 100*10⁻⁶ K⁻¹, mit Vorzug kleiner 10*10⁻⁶ K⁻¹, mit größerem Vorzug kleiner 1*10⁻⁶ K⁻¹, mit größtem Vorzug kleiner 0.1*10⁻⁶K⁻¹, mit allergrößtem Vorzug kleiner 0.01*10⁻⁶ K⁻¹, am idealsten 0 K⁻¹.

Indem eine zumindest in Bondrichtung B elastische, insbesondere an Zwischenräumen der Chips zumindest teilweise unterbrochene, Schicht zum Druckausgleich vorgesehen ist, werden durch die Druckübertragungseinrichtung auch Dehnungen, Spannungen und Höhenunterschiede in Bondrichtung B ausgeglichen, so dass eine homogene Druckbeaufschlagung ermöglicht wird. Die elastische Schicht dient somit als Kompensationsschicht. Insbesondere weist die elastische Schicht ein Elastizitätsmodul zwischen 1 MPa und 100 GPa, vorzugsweise zwischen 1 MPa und 10 GPa, noch bevorzugter zwischen 1 MPa und 1 GPa, auf. Bevorzugte Materialien sind Polymere. Als Vergleichswert des Elastizitätsmoduls dient Kautschuk mit einem effektiven isotropen Elastizitätsmodul von ungefähr 1 MPa. Faserverstärkte Polymere sind bevorzugt mit einem effektiven Elastizitätsmodul entlang der Faserlängsachse von circa 100 GPa. Diese markieren die Obergrenze des elastischen Materials.

In einer weiteren, vorteilhaften Ausführungsform der Erfindung ist vorgesehen, dass zwischen dem Druckkörper und den Chips eine harte, insbesondere an Zwischenräumen der Chips zumindest teilweise unterbrochene, Schicht zur unmittelbaren Druckübertragung auf die Chips vorgesehen ist. Die harte Schicht weist einen größeren Elastizitätsmodul (insbesondere doppelt so groß) als die elastische Schicht auf, wobei die harte Schicht als Schutzschicht dient. Insbesondere dient die harte Schicht auch dazu, eine plane Oberfläche auszubilden, insbesondere mit einer mittleren Oberflächenrauigkeit kleiner 10 µm, vorzugsweise kleiner 1 µm, noch bevorzugter kleiner 100 nm, am Bevorzugtesten kleiner 10 nm. Vorzugsweise wird die harte Schicht als ultraharte Schicht ausgebildet. Bevorzugte Materialien sind Metalle und Keramiken, insbesondere Eisenwerkstoffe, Buntmetalle, Hartmetalle, Nitridschichten, Karbidschichten, Boridschichten, Oxidkeramiken. Die Dicke der harten Schicht in Bondrichtung B ist kleiner als 10 mm, bevorzugter kleiner 5 mm, noch bevorzugter kleiner 2 mm, am bevorzugtesten kleiner 500 µm, am aller bevorzugtesten kleiner als 100 µm.

Mit Vorteil ist gemäß einer weiteren Ausführungsform vorgesehen, dass der Druckkörper am Umfang der ersten Druckseite angeordnete Fixierstellen, insbesondere in Form eines, vorzugsweise ringförmigen, Rücksprungs, aufweist. Auf diese Weise ist eine platzsparende Fixierung des Druckkörpers an dem Haltekörper möglich, wobei auf Grund einer etwaigen Wärmeübertragung von dem Haltekörper bis zu den zu bondenden Chips beim Bonden eine möglichst dünne Ausgestaltung der Druckübertragungseinrichtung in Bondrichtung B von Vorteil ist.

Für die erfindungsgemäße Bondvorrichtung gelten die beschriebenen Merkmale der Druckübertragungseinrichtung analog.

Weitere Vorteile, Merkmale und Einzelheiten der Erfindung ergeben sich aus der Beschreibung bevorzugter Ausführungsbeispiele sowie anhand der Zeichnungen. Diese zeigen in:
- Figur 1: eine schematische Seitenansicht der erfindungsgemäßen Bondvorrichtung,
- Figur 2a: eine schematische Detailansicht der erfindungsgemäßen Bondvorrichtung in einer ersten Ausführungsform,
- Figur 2b: eine schematische Ansicht einer erfindungsgemäßen, weiteren Ausführungsform der Druckübertragungseinrichtung,
- Figur 2c: eine schematische Seitenansicht der erfindungsgemäßen Druckübertragungseinrichtung in einer weiteren Ausführungsform,
- Figur 3a: eine schematische Detailansicht einer weiteren Ausführungsform der erfindungsgemäßen Bondvorrichtung,
- Figur 3b: eine schematische Seitenansicht der erfindungsgemäßen Druckübertragungseinrichtung in einer weiteren Ausführungsform und
- Figur 3c: eine schematische Seitenansicht der erfindungsgemäßen Druckübertragungseinrichtung in einer weiteren Ausführungsform.

In den Figuren sind gleiche oder gleichwirkende Bauteile mit den gleichen Bezugszeichen gekennzeichnet.

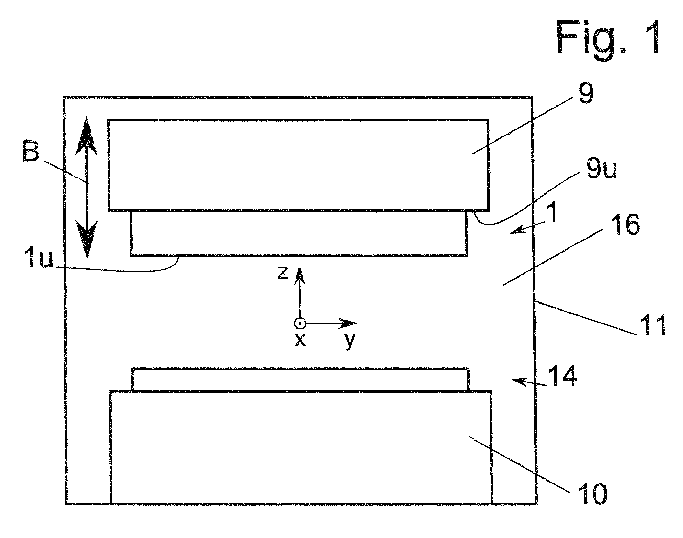

Figur 1 zeigt in schematischer und stark vereinfachter Darstellung einer Bondvorrichtung mit einem eine Bondkammer 16 umschließenden Gehäuse 11, die über eine nicht dargestellte, mit einer nicht dargestellten Tür verschließbare Öffnung be- und entladen werden kann. In der Bondkammer 16 ist eine definierte Atmosphäre und Temperatur einstellbar, wofür entsprechende Zu- und Ableitungen respektive Heizmittel vorgesehen sein können. Als Heizmittel dienen insbesondere der Haltekörper 9 und/oder die Aufnahme 10.

Am Boden der Bondkammer 16 ist eine Aufnahme 10 zur Aufnahme eines Produktsubstrats 14 vorgesehen, wobei eine Fixierung des Produktsubstrats insbesondere durch Vakuumbahnen, mechanische Klemmung oder durch Elektrostatik erfolgen kann.

Das Produktsubstrat 14 besteht aus einem Substrat 12, das auf der Aufnahme 10 aufliegt und an dieser fixiert wird und auf dem Substrat 12 temporär fixierten Chips 13, zu deren permanenter Fixierung die Bondvorrichtung vorgesehen ist.

Oberhalb der Aufnahme 10 ist ein Haltekörper 9 vorgesehen, wobei der Haltekörper 9 gegenüber der Aufnahme 10 relativbeweglich ist, und zwar in einer X-, einer Y- und einer Z-Richtung. Der Haltekörper 9 kann mit Vorzug auch um die X-, Y- und/oder Z-Achse gedreht werden um einen Keilfehler auszugleichen oder die Orientierung der Oberflächen zueinander zu verbessern. Die Relativbewegung erfolgt bevorzugt durch Bewegung des Haltekörpers 9, während die Aufnahme 10 starr ist beziehungsweise keine Freiheitsgrade aufweist.

Nach Beladen des Produktsubstrats 14 in die Bondkammer 16 und Anbringen einer Druckübertragungseinrichtung 1 an einer Unterseite 9u des Haltekörpers 9 wird die Druckübertragungseinrichtung 1 gegenüber dem Produktsubstrat 14 ausgerichtet und abgesenkt, bis die Druckübertragungseinrichtung 1 an ihrer dem Produktsubstrat 14 gegenüberliegenden Seite 1u anliegt und durch eine entsprechende Steuerung der Bewegung in Bondrichtung B wird eine definierte Bondkraft auf eine Chipoberfläche 13o der Chips 13 ausgeübt. Gleichzeitig oder anschließend wird das Produktsubstrat 14 auf eine Bondtemperatur aufgeheizt. Der Prozess wird durch eine Steuereinrichtung gesteuert.

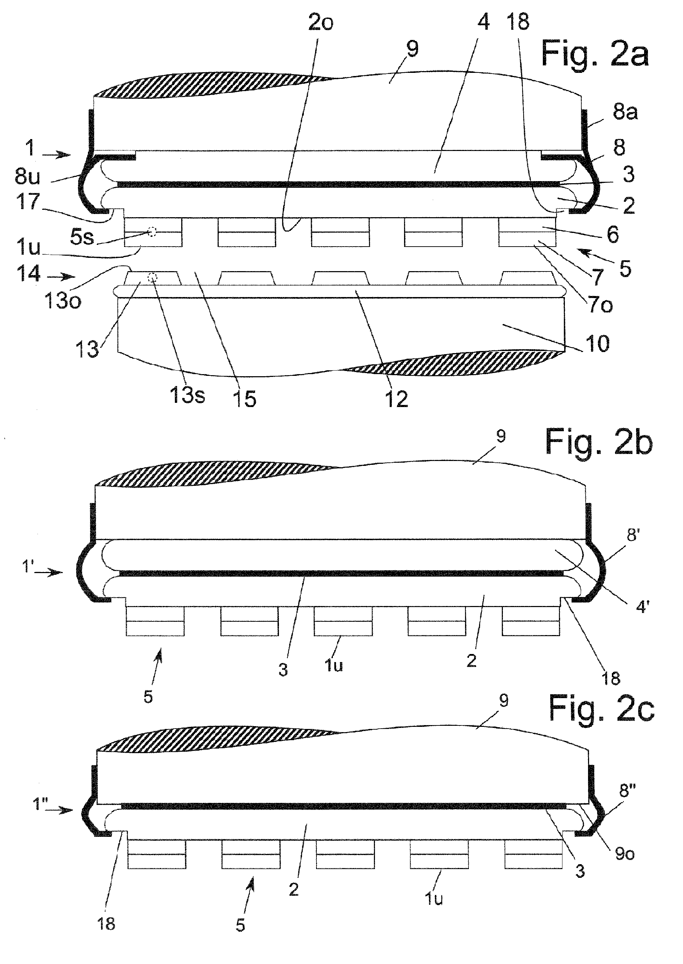

In Figur 2a sind die Druckübertragungseinrichtung 1 und das Produktsubstrat 14 im Detail dargestellt, wobei die Relationen der dargestellten Teile aus Darstellungszwecken stark schematisiert sind und, insbesondere die Chips 13, nicht den wahren Gegebenheiten entsprechen.

Bei der ersten gezeigten Ausführungsform gemäß Figur 2a weist die Druckübertragungseinrichtung 1 neben einem Druckkörper 2, den alle Ausführungsformen aufweisen, zusätzlich einen Haltekörper 4 auf, der mit dem Druckkörper 2 über ein Fixiermittel 8 in Form mehrerer, am Umfang des Druckkörpers 2 und des Haltekörpers 4 aufgeclipsten Klemmen zusammengeklemmt ist.

Zwischen dem Druckkörper 2 und dem Haltekörper 4 ist eine Gleitschicht 3, insbesondere vollflächig, vorgesehen, durch die eine gleitende Bewegung des Druckkörpers 2 quer zur Bondrichtung B ermöglicht wird.

Der Druckkörper 2 und der Haltekörper 4 sind insbesondere annähernd spiegelbildlich (gespiegelt an der Gleitschicht 3) ausgebildet.

An dem Haltekörper 9 der Bondvorrichtung wird die Druckübertragungseinrichtung 1 durch das Fixiermittel 8, insbesondere an den Klemmen angeformte Arme 8a fixiert. Alternativ oder zusätzlich kann der Haltekörper 4 an dem Haltekörper 9 durch Vakuumbahnen fixiert werden.

Die Fixiermittel 8 weisen einen U-förmigen Abschnitt 8u auf, zwischen dessen Armen die Klemmung des Druckkörpers 2 mit dem Haltekörper 4 erfolgt. Der U-förmige Abschnitt 8u umschließt somit einen Teil des Umfangs des Druckkörpers 2 und des Haltekörpers 4. Zum Eingriff des U-förmigen Abschnitts 8u sind am Druckkörper 2 an einer ersten Druckseite 2o Fixierstellen 17 angeordnet, insbesondere in Form eines, insbesondere vorzugsweise ringförmigen Rücksprungs am Umfang des Druckkörpers 2. Quer zur Bondrichtung B ist an der Fixierstelle ein Spiel 18 vorgesehen, damit eine gleitende Bewegung des Druckkörpers 2 quer zur Bondrichtung B ermöglicht wird.

Der gegenüberliegende Arm des U-förmigen Abschnitts 8u greift in eine korrespondierende Fixierstelle des Haltekörpers 4, wobei hier mit Vorzug eine Fixierung ohne Spiel vorgesehen ist.

An einer ersten Druckseite 2o des Druckkörpers 2, die von der Gleitschicht 3 abgewandt ist, sind Druckelemente 5 angebracht, und zwar an zu den Chips 13 auf dem Substrat 12 korrespondierende Positionen entlang der X-und Y-Richtung, also entlang der ersten Druckseite 2o. Die Druckelemente 5 bestehen aus einer elastischen Schicht 6, die jeweils korrespondierend zu Zwischenräumen 15 zwischen den Chips 13 unterbrochen ist und einer auf der elastischen Schicht 6 jeweils aufgebrachten harten Schicht 7. Diese ist ebenfalls analog der elastischen Schicht 6 im Bereich der Zwischenräume 15 unterbrochen, so dass etwaige quer zu der Bondrichtung verlaufende Seitenkräfte bei einer Druckbeaufschlagung der Chips 13 minimiert werden.

Bei einer Druckbeaufschlagung der Chips 13 mit der Druckfläche 1u, hier an einer Oberfläche 7o der harten Schicht 7, wobei jeweils Schwerpunkte 5s der Druckelemente 5 zentriert zu Schwerpunkten 13s der einzelnen Chips 13 ausgerichtet sind. Durch die ähnlichen oder identischen thermischen Ausdehnungskoeffizienten des Druckkörpers 2 und des Substrats 12 und durch die weitgehend reibungsfreie Relativbewegung des Druckkörpers 2 quer zur Bondrichtung B folgen die Druckelemente 5 exakt den Chips 13, so dass keine Querverschiebungen und Querkräfte verursacht werden.

In der Figur 2b ist ein vereinfachtes Fixiermittel 8' vorgesehen, bei dem die Fixierung des Druckkörpers 2 und des Haltekörpers 4 durch ein modifiziertes Fixiermittel 8' erfolgt, das ausschließlich an Fixierstellen des Druckkörpers 2, nicht jedoch an dem Haltekörper 4 fixiert, so dass die Fixierung in Bondrichtung B zwischen dem Druckkörper 2 und dem Haltekörper 9 erfolgt. Die Kinematik des Druckkörpers 2 und der Gleitschicht 3 mit dem Spiel 18 ist die bei der Figur 2a. Es ergibt sich somit eine geänderte Druckübertragungseinrichtung 1' in einfacherer Ausführung, da das Fixiermittel 8' und der Haltekörper 4' einfacher ausgeführt sind.

Bei der Ausführungsform gemäß Figur 2c wird auf den Haltekörper 4 verzichtet und die Gleitschicht 3 direkt zwischen dem Druckkörper 2 und dem Haltekörper 9 vorgesehen. Es ergibt sich eine geänderte Druckübertragungseinrichtung 1 ", die einfacher als die vorbeschriebenen Druckübertragungseinrichtungen 1, 1' ausgebildet sind, da auf einen Haltekörper 4, 4' verzichtet werden kann und die Druckübertragungsrichtung 1" dünner ausgebildet werden kann und die Wärme besser überträgt, soweit diese von dem Haltekörper 9 erzeugt wird.

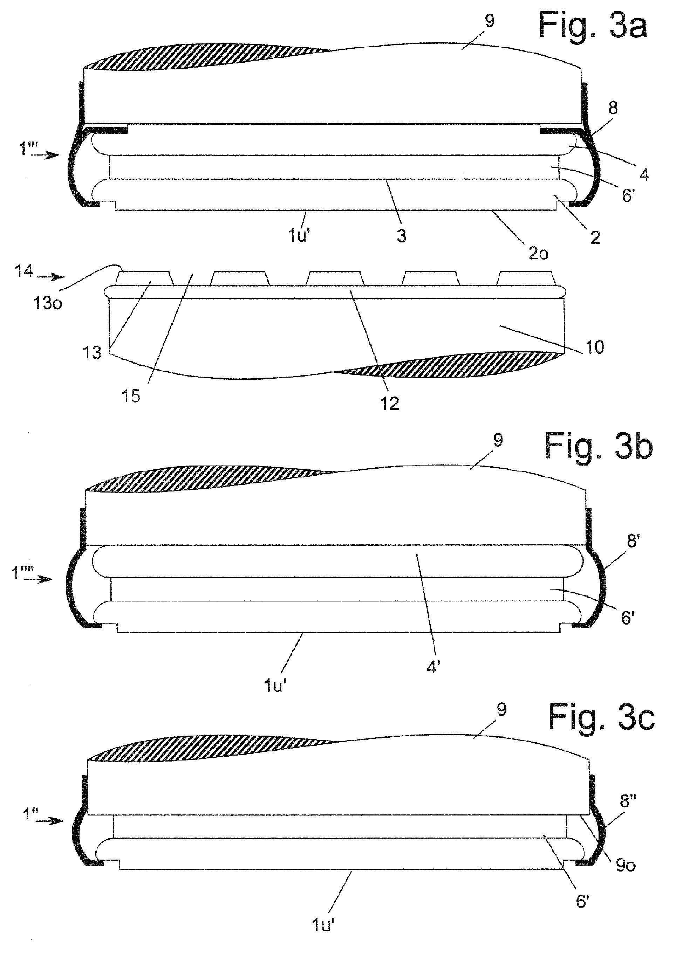

Bei der in Figur 3a gezeigten Ausführungsform wird dagegen auf die in den Figuren 2a bis 2c gezeigten Druckelemente 5 verzichtet, so dass die erste Druckseite 2o des Druckkörpers 2 die Funktion der harten Schicht 7 übernimmt. Eine elastische Schicht 6' ist zwischen dem Druckkörper 2 und dem Haltekörper 4 vorgesehen. An der Grenzfläche zwischen der elastischen Schicht 6' und dem Druckkörper 2 ist die Gleitschicht 3 vorgesehen, während das Fixiermittel 8 dem Fixiermittel 8 aus Figur 2a entspricht. Es ergibt sich somit eine geänderte Ausführungsform der Druckübertragungseinrichtung 1"'.

Die erste Druckseite 2o wirkt bei dieser Ausführungsform als Druckfläche 1u', mit der Druck auf die Chipoberfläche 13o der Chips 13 ausgeübt wird.

Bei der in Figur 3b gezeigten Ausführungsform sind entsprechend der in 2b gezeigten Ausführungsform die Fixiermittel 8' vorgesehen, die auf einen Eingriff mit dem Haltekörper 4' verzichten. Es ergibt sich somit eine geänderte Ausführungsform der Druckübertragungseinrichtung 1"".

In der in Figur 3c gezeigten Ausführung der Druckübertragungseinrichtung 1""' wird auf den Haltekörper 4, 4' auf den Haltekörper 4, 4' verzichtet, entsprechend der in Figur 2c beschriebenen Ausführung. Entsprechend werden auch Fixiermittel analog den Fixiermitteln 8" verwendet.

### Bezugszeichenliste

- 1, 1', 1", 1"', 1"": Druckübertragungseinrichtung
- 1u, 1u': Druckflächen
- 2: Druckkörper
- 2o: erste Druckseite
- 2f: zweite Druckseite
- 3: Gleitschicht
- 4, 4': Haltekörper
- 5: Druckelement
- 6, 6': elastische Schicht
- 7: harte Schicht
- 8, 8', 8": Fixiermittel
- 8a: Arme
- 8u: u-förmiger Abschnitt
- 9: Haltekörper
- 9u: Unterseite
- 10: Aufnahme
- 11: Gehäuse
- 12: Substrat
- 13: Chips
- 13o: Chipoberfläche
- 13s: Schwerpunkt
- 14: Produktsubstrat
- 15: Zwischenräume
- 16: Bondkammer
- 17: Fixierstellen
- 18: Spiel
- Bondrichtung: B

## Patentansprüche

1. Druckübertragungseinrichtung zum Bonden einer Vielzahl von Chips (13) auf ein Substrat (12) mit:
- einem Druckkörper (2) zur Beaufschlagung der Chips (13) mit einer in Bondrichtung (B) wirkenden Bondkraft, wobei der Druckkörper (2) eine erste Druckseite (2o) und eine gegenüberliegende zweite Druckseite (2f) aufweist, die quer zur Bondrichtung (B) verlaufen,
- am Umfang der Druckübertragungseinrichtung (1) anbringbaren Fixiermitteln (8, 8', 8") zur Fixierung der Druckübertragungseinrichtung (1) an einem Haltekörper (9) in der Bondrichtung (B), und
- einer Gleitschicht (3) zur gleitenden Bewegung des Druckkörpers (2) quer zur Bondrichtung (B),
**dadurch gekennzeichnet, dass** die Fixiermittel (8, 8', 8")
a) quer zur Bondrichtung (B) elastisch ausgebildet sind und/oder
b) als Klemmen zur Klemmung des Druckkörpers (2) in Richtung des Haltekörpers (9), insbesondere mit dazwischen angeordneter Gleitschicht (3), ausgebildet sind.

2. Druckübertragungseinrichtung nach Anspruch 1, wobei eine zumindest in Bondrichtung (B) elastische Schicht (6) zum Druckausgleich vorgesehen ist.

3. Druckübertragungseinrichtung nach einem der vorhergehenden Ansprüche, bei der zwischen dem Druckkörper (2) und den Chips (13) eine harte Schicht (7) zur unmittelbaren Druckübertragung auf den Chips (13) vorgesehen ist.

4. Druckübertragungseinrichtung nach einem der vorhergehenden Ansprüche, bei der der Druckkörper (2) am Umfang der ersten Druckseite (2o) angeordnete Fixierstellen, insbesondere in Form eines, vorzugsweise ringförmigen, Rücksprungs, aufweist.

5. Bondvorrichtung zum Bonden einer Vielzahl von Chips (13) auf ein Substrat (12) mit:
- einer Druckübertragungseinrichtung (1) nach einem der vorhergehenden Ansprüche,
- dem Haltekörper (9),
- einer Aufnahme (10) zur Aufnahme des Substrats (12),
- Heizmitteln zum Heizen der Chips (13) und des Substrats (12),
- Antriebsmitteln zum Erzeugen der Bondkraft, insbesondere durch Bewegung des Haltekörpers (9) in Bondrichtung (B).

6. Verfahren zum Bonden einer Vielzahl von Chips (13) auf ein Substrat (12) mit einer Druckübertragungseinrichtung (1) nach einem der Ansprüche 1 bis 4 oder einer Bondvorrichtung nach Anspruch 5.

7. Verfahren nach Anspruch 6, wobei der Druckkörper (2), insbesondere hinsichtlich Material und/oder Abmessungen, derart gewählt wird, dass seine Wärmeausdehnungseigenschaften zumindest in Querrichtung zur Bondrichtung (B) mit den Wärmeausdehnungseigenschaften des Substrats (12) korrespondieren.

## Claims

1. A pressure transmission apparatus for bonding a plurality of chips (13) to a substrate (12) with:
- a pressure body (2) for applying a bonding force which acts in the bonding direction (B) to the chip (13), the pressure body (2) having a first pressure side (2o) and an opposite second pressure side (2f) which run transversely to the bonding direction (B),
- fixing means (8, 8', 8") which can be attached to the periphery of the pressure transmission apparatus (1) for fixing of the pressure transmission apparatus (1) on a retaining body (9) in the bonding direction (B), and
- a sliding layer (3) for sliding motion of the pressure body (2) transversely to the bonding direction (B),
**characterized in that** the fixing means (8, 8', 8")
a) being made elastic transversely to the bonding direction (b) and/or
b) are made as clamps for clamping of the pressure body (2) in the direction of the retaining body (9), especially with a sliding layer (3) located in between.

2. The pressure transmission apparatus as claimed in Claim 1, wherein there is a layer (6) which is elastic at least in the bonding direction (B) and especially which is at least interrupted on intermediate spaces (15) of the chip (13) for pressure compensation.

3. The pressure transmission apparatus as claimed in one of the preceding claims, in which between the pressure body (2) and the chip (13) there is a hard layer (7) which is interrupted especially on intermediate spaces (15) of the chip (13) for direct pressure transmission to the chips (13).

4. The pressure transmission apparatus as claimed in one of the preceding claims, in which the pressure body (2) has fixing sites which are located on the periphery of the first pressure side (2o), especially in the form of a preferably ring-shaped offset.

5. A bonding device for bonding a plurality of chips (13) to a substrate (12) with:
- a pressure transmission apparatus (1) as claimed in one of the preceding claims,
- the retaining body (9),
- a receiver (10) for accommodating the substrate (12),
- heating means for heating of the chip (13) and of the substrate (12),
- drive means for producing the bonding force, especially by movement of the retaining body (9) in the bonding direction (B).

6. Method for bonding a plurality of chips (13) on a substrate (12) with a pressure transmission apparatus (1) according to claim 1 or a bonding device according to claim 5.

7. Method according to claim 6, wherein the pressure body (2), especially with respect to material and/or dimensions, is chosen such that its thermal expansion properties at least in the transverse direction to the bonding direction (B) correspond to the thermal expansion properties of the substrate (2).

## Revendications

1. Dispositif de transmission de pression pour lier une pluralité de puces (13) sur un substrat (12) comprenant :
- un corps de pression (2) pour fournir aux puces (13) une force de liaison agissant dans le sens de liaison (B), sachant que le corps de pression (2) présente une première face de pression (2o) et une seconde face de pression opposée (2f) qui sont transversales au sens de liaison (B),
- des moyens de fixation (8, 8', 8") pouvant être appliqués sur le pourtour du dispositif de transmission de pression (1) pour fixer le dispositif de transmission de pression (1) sur un corps de fixation (9) dans le sens de liaison (B), et
- une couche de glissement (3) pour le mouvement par glissement du corps de pression (2) transversalement au sens de liaison (B),
**caractérisé en ce que** les moyens de fixation (8, 8', 8")
a) sont conçus élastiques transversalement au sens de liaison (B) et/ou
b) sont conçus en tant que pinces pour pincer le corps de pression (2) en direction du corps de fixation (9), en particulier avec la couche de glissement (3) disposée entre.

2. Dispositif de transmission de pression selon la revendication 1, dans lequel une couche (6) élastique au moins dans le sens de liaison (B) est prévue pour équilibrer la pression.

3. Dispositif de transmission de pression selon l'une des revendications précédentes, dans lequel une couche dure (7) pour la transmission directe de pression sur les puces (13) est prévue entre le corps de pression (2) et les puces (13).

4. Dispositif de transmission de pression selon l'une des revendications précédentes, dans lequel le corps de pression (2) présente des points de fixation disposés sur le pourtour de la première face de pression (2o), en particulier sous forme d'un retrait qui est de préférence annulaire.

5. Dispositif de liaison pour lier une pluralité de puces (13) sur un substrat (12) comprenant :
- un dispositif de transmission de pression (1) selon l'une des revendications précédentes,
- le corps de fixation (9),
- une réception (10) pour recevoir le substrat (12),
- des moyens de chauffage pour chauffer les puces (13) et le substrat (12),
- des moyens d'entraînement pour produire une force de liaison, en particulier par le mouvement du corps de fixation (9) dans le sens de fixation (B).

6. Dispositif de liaison pour lier une pluralité de puces (13) sur un substrat (12) comprenant un dispositif de transmission de pression (1) selon l'une des revendications 1 à 4 ou un dispositif de liaison selon la revendication 5.

7. Procédé selon la revendication 6, dans lequel le corps de pression (2), en particulier en ce qui concerne le matériau et/ou les dimensions, est ainsi choisi que ses propriétés de dilatation thermique correspondent aux propriétés de dilatation thermique du substrat (12), au moins dans le sens transversal au sens de liaison (B).
